# EUROPEAN PATENT SPECIFICATION

(11) **EP 3 799 545 B1**
(45) Date of publication and mention of the grant of the patent: **12.06.2024**
(21) Application number: 20198816.9
(22) Date of filing: 28.09.2020
(51) Int. Cl.: H05K 5/00, B60R 16/023, H01R 12/72, G07C 5/08, H01R 13/66

(54) **ON-BOARD DIAGNOSTICS CONNECTOR DEVICE**
VERBINDUNGSVORRICHTUNG FÜR BORDEIGENE DIAGNOSTIK
DISPOSITIF DE CONNECTEUR À DIAGNOSTIC EMBARQUÉ

(30) Priority: 26.09.2019 GB 201913917
(43) Date of publication of application: 31.03.2021
(73) Proprietor: Bridgestone Mobility Solutions B.V., 1083 HK Amsterdam (NL)
(72) Inventor: FISCHER, Karsten, 04277 Leipzig (DE); FISCHER, Tobias, 04435 Schkeuditz (DE); HAGENAU, Thomas, 04552 Borna (DE); GIANFRANCO, Santoro, 08034 Barcelona (ES)
(74) Representative: Dehns

(56) References cited:
- EP-A1- 3 503 698
- EP-A1- 3 522 305
- WO-A1-2018/066012
- US-A1- 2013 066 514
- US-A1- 2015 171 529

## Description

### FIELD OF THE INVENTION

The present invention relates to devices, such as On-Board Diagnostics (OBD) devices, (e.g. vehicle telematics devices), which comprise a connector configured to connect with a port, e.g. the OBD port of a vehicle. The present invention also relates to methods of using and manufacturing such devices.

### BACKGROUND

Modern vehicles use On-Board Diagnostics (OBD) to monitor various vehicle systems, and to obtain information about the functioning of the vehicle. This information may include, but is not limited to, the vehicle's speed, position, emissions, RPM, and fuel economy, as well as further parameters of particular components such as the vehicle engine or battery. OBD data may be used to analyse the operation of a vehicle; in particular such data has been used for some time to identify faults, or verify correct operation of a vehicle as part of the maintenance thereof. OBD data is also increasingly used to provide insights in the field of vehicle telematics. Vehicle telematics systems using OBD data may enable aspects of the operation of vehicle, and in some cases driver behaviour, to be monitored remotely. Such systems may be used in the context of fleet management, e.g. to track vehicles and monitor fuel efficiency.

An OBD device needs to be able to communicate with the OBD system of a vehicle in order to be able to obtain OBD data. This can be done by plugging the OBD device into an OBD port of the vehicle. The OBD port is configured to interface with a connector of external equipment, such as an OBD device, to enable communication between the vehicle and external equipment, including the communication of OBD data from the vehicle to an OBD device.

The OBD port used in the majority of modern vehicles is largely standardized worldwide, currently according to the "OBD-II" standard. OBD ports are typically in accordance with ISO 15031, which specifies certain details in relation to; port location/access, port design, port contact allocation, and electrical requirements for the port and related electrical circuits. The standard also specifies certain details in relation to the cooperating connector associated with equipment to be connected to the port, including connector design, connector contact allocation and electrical requirements for the port and related electrical circuits. The standard defines certain minimum dimensional requirements in relation to the port and cooperating connector. SAE J1962 is a further standard providing similar specifications for the OBD port and cooperating connector. Typical OBD ports in accordance with these standards are in the form of a socket, having two rows of holes for receiving pins of a mating connector of external equipment. In some exemplary arrangements, there may be an 8.6mm distance between the two rows of holes. Each row contains up to 8 pin-receiving holes.

The design of an OBD device which may cooperate with an OBD port presents some challenges.

An OBD device, such as a vehicle telematics device, is removably connected to the vehicle's OBD connecter, and may be left in place for an extended period of time. The OBD device may be designed to transmit OBD data wirelessly from the vehicle's network to another (radio) network. It is desirable that the device, in particular the pins which are received by the vehicle's OBD port, should be robust, and able to function reliably over long periods of time.

The OBD port of a vehicle is usually (e.g. in arrangements according to the requirements of ISO 15031), located below the driver's end of the vehicle instrument panel, a region in which space is typically constrained. There are therefore constraints on the size of the OBD device, particularly if the OBD device is to be left in place over long periods of time, and it is desirable that the OBD device uses this limited space as efficiently as possible.

In order to operate, for example by processing and transmitting the data obtained from the vehicle's OBD system, OBD devices contain various circuitry, implemented on a printed circuit board (PCB). Such circuitry may provide one or more processors of the OBD device. This circuitry is connected to a plurality of pins, arranged to be received by an OBD port e.g. according to the aforementioned standards, so as to enable the OBD device to be plugged into the OBD port. The plugging of these pins into the connector of an OBD port holds the OBD device in place, and as such it is important that these pins are robust and able to withstand the considerable forces used when the user plugs the OBD device into an OBD port, as well as any on-going stress placed on the pins by their engagement with the OBD port.

In this regard, the alignment of the pins is important. Poorly aligned pins mean that plugging the device into an OBD port requires a higher degree of force, placing additional stress on the pins. Misalignment can also place stress on the pins once the device is plugged into a vehicle's OBD port, as a result of the force they are placed under to conform to the sockets of the OBD port. If pins are poorly aligned, their soldering points are more liable to break, resulting in failure of the device.

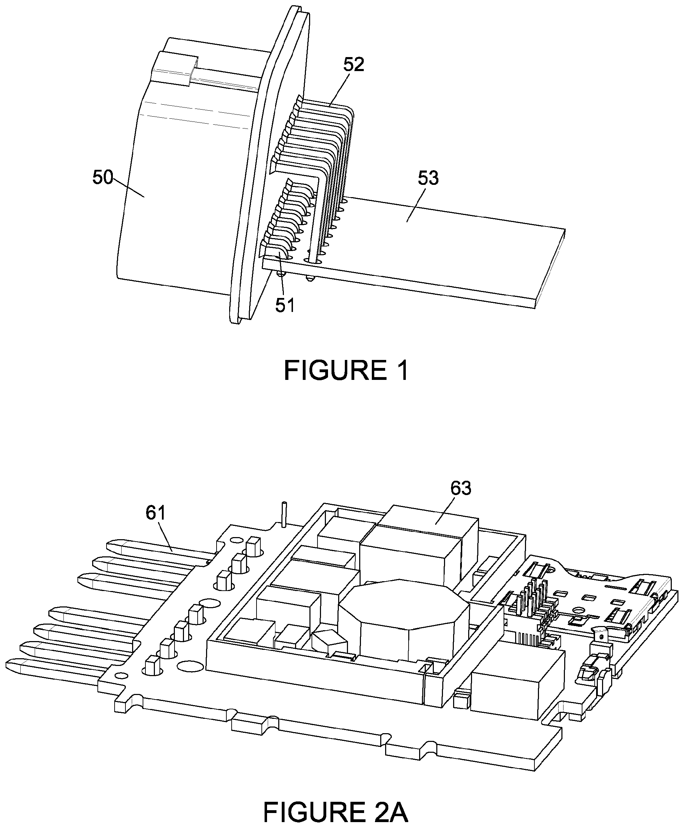

Certain of the internal parts of one ISO-15031 compatible OBD device arrangement is shown in Figure 1. This arrangement uses an individually designed "pin header" 50 to retain the two rows of pins 51, 52 and retain them located in contact with the PCB 53. Pin headers can be effective in maintaining alignment of the pins 51, 52, but are associated with certain drawbacks in the context of OBD devices. In order to provide the two pin rows 51, 52 required for connection to the standard OBD port, pins of a second row 52 are connected to the PCB behind pins of a first row 51, and are then bent up and over the first row 51. As such, the second pin row 52 requires more than double the volume of a single row. Such pin header arrangements thus take up valuable space when installed in an OBD port, as a result of this inefficient arrangement.

Pin headers may also be large and heavy, with a balance point outside the PCB area. In order to keep the pin header in place, "through-hole" assembly is required to fix the pin header to the PCB. Through-hole assembly involves the use of leads on a component being inserted into holes in the PCB, which are then soldered to pads on the opposite side of the PCB. Through-hole assembly may be relatively expensive, unsuited to automation, and uses a considerable amount of space on a PCB.

Certain of the internal parts of another ISO-15031 compatible OBD device arrangement are shown in Figure 2A. This device does not use a pin header, but instead the individual pins 61 are inserted into holes in the PCB 63, and are then soldered to the PCB 63. Each pin 61 is independently supported by its soldered connection to the PCB 63.

A connector housing of the device, which is not shown, must include slots for each pin 61 which is attached to the PCB 63. During assembly of the device, the pins are inserted through the holes from the reverse of the connector as shown in Figure 2A.

Manufacture of the device shown in Figure 2A requires each individual pin to be connected to the PCB independently on a per-pin basis. Because each pin 61 is placed independently, such techniques do not allow accurate alignment of the pins to be obtained, especially with regard to their parallelism.

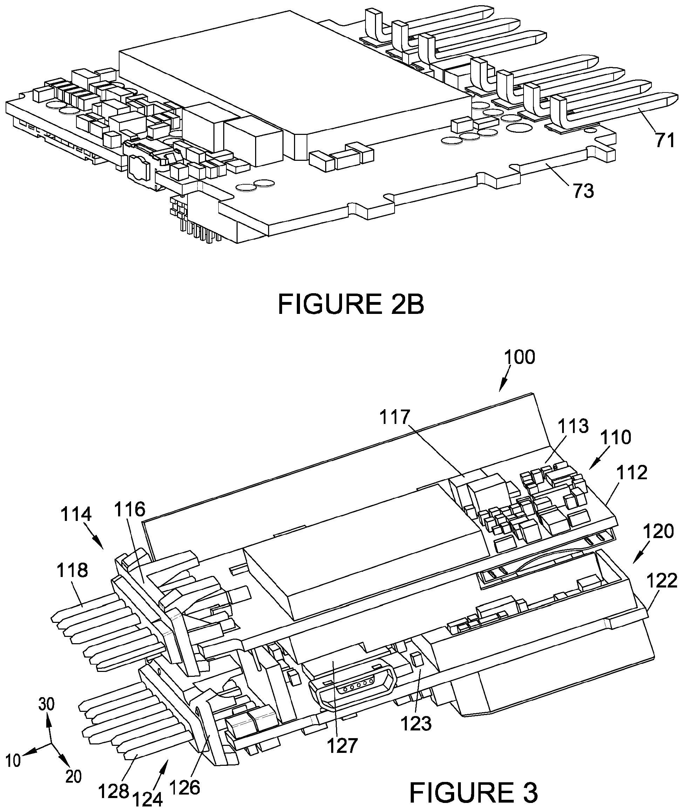

A similar device to that of Figures 2A is shown in Figure 2B. The device of Figure 2B can be manufactured using "surface mount technology" (SMT). SMT is a method of PCB assembly in which components are placed directly onto a PCB, along with solder paste, and the PCB is conveyed into a reflow soldering oven where the solder paste melts to bond the components to the PCB. The placement of the components may be performed by a "pick-and-place" machine which picks the component up, commonly using some form of suction, and places it on the PCB.

In order to obtain such a device, each pin 71 is surface mounted to the PCB 73 using a special assembling fixture process. This requires that each individual pin 71 is picked and
placed independently, in a per-pin assembly method. Because each pin 71 is placed independently, as with the device of Figure 2A, such techniques do not allow accurate alignment of the pins 71 to be obtained, especially with regard to their parallelism. Additionally, the pins 71 are required to be held by a fixture during soldering, as the balance point of the pins 71 is outside the footprint of the PCB.

The per-pin assembly methods required to manufacture the devices of Figures 2A-B do not allow pins to be accurately aligned, or strongly supported. In particular, when a device manufactured using such a per-pin manufacturing method is plugged into a vehicle's OBD port, the misalignment of these pins may introduce stress into the weak soldered connection with the PCB, as discussed above.

The Applicant has realised that there remains a need for an improved OBD device comprising a connector configured to connect with an On-Board Diagnostics (OBD) port of a vehicle.

Patent application No. EP 3522305 A1 discloses an on-board diagnostic connector terminal including a plurality of first pins, a plurality of second pins and a substrate. Each first pin includes a first section and a second section. The first section connects to the second section. The first section includes a first connection end, and the second section includes a first soldering end. Each second pin includes a second connection end and a second soldering end. The first pins and the second pins are disposed on the substrate. The first soldering ends and the second soldering ends are arranged on a first straight line. At least one first connection end and the second connection end corresponding thereto are arranged linearly in a first direction. The first direction is perpendicular to the first straight line.

Patent application No. US 2015/171529 A1 discloses a plug and a PCB assembly. The plug includes a plug body, where a first row of slots and a second row of slots are disposed on the plug body; and the plug further includes first pins in one-to-one correspondence with the first row of slots and second pins in one-to-one correspondence with the second row of slots; the first pin is L-shaped, and the other end is configured to connect to a first PCB. The second pin is stair-shaped, one end of the second pin is embedded in a slot, in a corresponding position, of the second row of slots, and the other end is configured to connect to the first PCB.

### SUMMARY

In accordance with a first aspect of the present invention there is provided a sub-assembly for an On-Board Diagnostics (OBD) device, the sub-assembly comprising a first PCB assembly and a second PCB assembly. Each one of the first and second PCB assemblies comprises a PCB and a pin assembly. Each pin assembly comprises a pin carrier; and a row of parallel pins retained by the pin carrier, wherein each pin of the row of pins comprises a proximal portion extending from one side of the pin carrier, at least a proximal end of the pin being connected to the PCB, and a distal portion extending from an opposite side of the pin carrier for providing a pin contact of the device, wherein the row of parallel pins retained by the pin carrier provides a row of parallel pin contacts.

The first and second PCB assemblies are located relative to one another to enable the rows of parallel pin contacts provided by the first and second PCB assemblies respectively to provide respective ones of rows of parallel pin contacts of a connector of the device in use, the pin contacts being arranged so as to be receivable by openings of an OBD port when the OBD device is connected to an OBD port of a vehicle.

In embodiments, the first PCB assembly and the second PCB assembly are joined to one another. In some embodiments, the PCBs of the first and second PCB assemblies are electrically and mechanically joined together using first and second parts which may slide relative to one another over a given distance while still maintaining an electrical and mechanical connection between the assemblies. This may permit some degree of relative movement between the PCBs. The parts may be mating parts. For example, a plug and socket type arrangement may be used.

The present invention in this first aspect may include any or all of the features described in relation to any one of the following aspects of the invention, and vice versa, to the extent that they are not mutually inconsistent.

According to a second aspect of the invention, there is provided an On-Board Diagnostics (OBD) device configured to be connected to an OBD port of a vehicle in use, comprising; a first PCB assembly, and a second PCB assembly. Each one of the first and second PCB assemblies comprises a PCB, and a pin assembly. Each pin assembly comprises a pin carrier, and a row of parallel pins retained by the pin carrier, wherein each pin of the row of pins comprises a proximal portion extending from one side of the pin carrier, at least a proximal end of the pin being connected to the PCB, and a distal portion extending from an opposite side of the pin carrier for providing a pin contact of the device. The row of parallel pins retained by the pin carrier provides a row of parallel pin contacts. The first and second PCB assemblies are located relative to one another such that the rows of parallel pin contacts provided by the first and second PCB assemblies respectively provide respective ones of rows of parallel pin contacts of a connector of the OBD device, the pin contacts being arranged so as to be receivable by openings of an OBD port when the OBD device is connected to an OBD port of a vehicle.

The present invention provides an improved OBD device, in which each row of pins (for providing a row of pin contacts of a connector of the device) is connected to a respective PCB using a pin carrier. Thus, one PCB assembly, including a PCB and a pin assembly (which, in turn comprises a plurality of pins and a pin carrier), is provided in respect of each one of first and second rows of pin contacts of a connector of the device. It has been found that such arrangements may enable a device having a connector including multiple rows of pin contacts, compatible with an OBD port, to be provided in a simple and efficient manner, and without the need for a pin header.

Rather than connecting multiple rows of pins to a common PCB, each row of pin contacts is provided by a row of pins connected to its own respective PCB. As such there is no need to provide a second row of pins which is bent over a first row, and the available space can be used more efficiently. Consequently there is no need for a pin header to retain a bent pin arrangement.

As discussed above, e.g. in relation to Figure 1, the use of a pin header to retain two rows of pins may be associated with undesirable additional weight, and may require mounting using through-hole assembly. As the present invention may avoid the need to use a pin header, the use of through-hole assembly may, at least in preferred embodiments, be avoided. Through-hole assembly is relatively expensive and makes inefficient use of PCB space. Due to the through-hole assembly, the pin header also has to be attached after reflow soldering is applied to other components on the PCB. The attachment of the pin header therefore necessitates its own separate assembly steps of placing and soldering (e.g. by wave soldering or selective soldering), increasing production time, effort, and costs.

In accordance with the invention, because each pin within a given row of pins is connected to a common pin carrier for that row of pins, it is straightforward to ensure that all the pins of each row are correctly aligned with one another e.g. arranged in a straight row and are parallel with one another. This is in contrast with arrangements of the type shown in Figures 2A and 2B, which are assembled on a per-pin basis, where it can be particularly difficult to accurately align the pins in a parallel manner. The improved pin alignment which may be obtained in accordance with the invention may reduce the stress placed on the pins, both during the plugging of the device into an OBD port, and afterwards. As such, the likelihood of the soldered connections between the pins and the PCB breaking can be reduced in comparison with a device in which the pins have been assembled to the PCB on a per-pin basis.

It will be appreciated that, in accordance with the invention, first and second PCB assemblies are provided, each providing a respective row of parallel pin contacts of the connector of the OBD device. By the term "parallel pin contacts" it is meant that the pin contacts within each row of pin contacts are parallel with one another. The pin contacts within the row do not converge with one another or diverge from one another. The pins providing the pin contacts in a given row are similarly parallel with one another.

The term "row" will be understood to mean a series of pins or pin contacts generally arranged in a line, for example at least three pins or pin contacts generally arranged in a line. As will be described further below, the pin contacts being arranged so as to be receivable by openings of an OBD port of a vehicle may mean that the rows of parallel pins and pin contacts contain a certain minimum and/or maximum number of pin contacts. For example, each row of pin contacts may contain a maximum of 8 pin contacts. Furthermore, for the pin contacts to be receivable by openings of a standard OBD port of a vehicle, the rows of parallel pins and pin contacts may have a particular geometric layout.

In embodiments each pin of each one of the first and second PCB assemblies has a longitudinal axis along which it extends, and the longitudinal axes of the pins in the respective rows of pins provided by the first and second PCB assemblies are aligned in a first direction, wherein the respective rows of pins provided by each one of the first and second PCB assemblies each extend in a second direction perpendicular to the first direction. Thus, the pins in the first and second PCB assemblies each extend along the first direction, corresponding to the direction of the longitudinal axes of the pins. Each row of parallel pin contacts extends along a second direction, perpendicular to the first direction.

The rows of pins provided by the first and second PCB assemblies may be spaced from one another in a third direction, perpendicular to the first and second directions.

The rows of parallel pin contacts provided by the first and second PCB assemblies are substantially parallel to one another. Thus, the rows of pin contacts may be parallel rows of pin contacts, which are spaced apart from one another.

The pins within a given row of parallel pins (and hence the pin contacts) are spaced from one another along the row. The pins within the row do not contact one another. The pins in each row of parallel pins do not contact the pins in the other row of parallel pins.

Each one of the first and second PCB assemblies may provide only a single row of parallel pin contacts. Thus, in embodiments, each pin assembly includes only a single row of parallel pins.

The following features may refer to either one, or preferably each one of the first and second PCB assemblies.

Each pin in the row of pins comprises a proximal portion, being that portion extending from one side (a proximal side) of the pin carrier. The proximal side of the pin carrier is the side closest to a distal end of the PCB. Each pin comprises a distal portion, being that portion extending from an opposite side (a distal side) of the pin carrier. At least a distal tip defined by the distal portion of each pin extending from the opposed side of the pin carrier provides a pin contact of the device e.g. extends from a connector housing for insertion into an opening of the port. In embodiments the entire distal portion of the pin is exposed e.g. extends from a connector housing to provide a pin contact of the device.

In some embodiments, a distal face of the pin carrier provides a part of a back (or proximal) face of a connector housing. In such embodiments, the entire distal portion of a pin extending from the pin carrier will form a pin contact.

At least a proximal end of each pin is connected to the PCB. The connection may be a direct connection. The connection is an electrical connection. The connection is preferably a soldered connection. The solder bonds the pin to the PCB. In embodiments each pin is soldered to the PCB. References to a pin being connected to e.g. soldered to the PCB should be understood to require that at least a proximal end of each pin is connected e.g. soldered to the PCB. Thus, at least the proximal end of the proximal portion of the pin is connected e.g. soldered to the PCB, and in embodiments, the entire proximal portion extending from the pin carrier is connected e.g. soldered to the PCB.

Each pin in the row of pins may be connected to the same side of the PCB. The at least a proximal end of each pin may be located in face to face contact with the major surface of the PCB on the side thereof.

Each pin may have a flattened cross section. This will provide a flat surface for connection i.e. soldering to the PCB. For example, the pin may have a square or rectangular shape in cross section along a direction transverse to the longitudinal axis of the pin (e.g. the second direction).

The pins in a given row of pins provided by a PCB assembly may all be of the same length, or the row may include pins of differing lengths. For example, it may be desired for some pins to define a longer distal portion so as to provide pin contacts of differing lengths. Thus, the pin contacts of a given row may each be of the same length or may include pin contacts of differing lengths. The length or lengths of the pins (or pin contacts) within the two rows provided by the first and second PCB assemblies may be the same or different. Some of the pins (or pin contacts) in a given row may be of the same length, with only a subset of the pins (or pin contacts) being of different length. For example, a first PCB assembly may provide a row of pin contacts of identical length, while a second PCB assembly may provide a row of pin contacts including pin contacts of differing lengths.

In each PCB assembly, the pins of the respective row of pins may be arranged adjacent an edge of the PCB to which the pins are connected. The edge of the PCB is at a distal end of the PCB. The edge of each PCB may extend in the second direction. The pins may be arranged adjacent the edge such that at least a proximal end, (and optionally the entire proximal portion) of each pin is within the footprint of the PCB to which it is connected, and the distal portion of each pin is outside the footprint of the PCB to which it is connected. The pins associated with each PCB assembly are located at the same end of their respective PCBs i.e. the distal end.

Any suitable arrangement may be used to retain the pins relative to the pin carrier. The pins may be mounted to the pin carrier in any suitable manner. For example, the pins might be mounted so as to lie above or below a main body of the pin carrier. However, in preferred embodiments, each pin extends through the pin carrier.

Each pin may extend through a bore in the pin carrier by which it is retained. Each pin may then comprise an intermediate portion which is located within the bore of the pin carrier. By retaining each pin within a bore of a pin carrier, the parallelism of the pins of each row may be ensured in a particularly straightforward and space efficient manner. The intermediate portion of each pin may be outside the footprint of the PCB to which it is connected. References to a "footprint" of a PCB herein refer to the outer contour of a major surface of the PCB. In other words, something is within the "footprint" of a PCB, if it is within the volume extending above a major surface of the PCB in a direction normal to the major surface of the PCB.

The pins may be retained in their positions relative to the pin carrier in any suitable manner e.g. through an interference fit. In some embodiments one or more retaining features may be used to assist in retaining the pins in their respective positions relative to their pin carrier. The pin carrier and pins may comprise respective cooperating formations for retaining the pins in position relative to the pin carrier.

In embodiments in which each pin extends through a bore in the pin carrier by which it is retained, the bore may comprise one or more recess, and the intermediate portion of the pin may comprise one or more projection, each projection cooperating with a recess of the bore of the carrier through which the pin extends, to retain the pin in position relative to the carrier. A recess may be provided in respect of each projection. The one or more projection may extend perpendicular to the longitudinal axis of the pin. This arrangement may inhibit movement of the pin along its longitudinal axis relative to the pin carrier to which it is mounted. The protrusion extends in a radial direction relative to the axis of the pin. The recess is a recess from the sidewall of the bore. The recess extends in a radial direction relative to an axis of the bore. The recess may extend into the body of the carrier in the region surrounding the bore.

In accordance with any of the embodiments of the invention, each one of the pins is preferably substantially straight. Thus, each of the pins of the first and second rows of parallel pins provided by each one of the first and second PCB assemblies is preferably straight. Each one of the pins present in each row of pins is preferably straight. This may provide a more robust arrangement, overcoming the drawbacks of arrangements described above, which use bent pins. A straight pin herein refers to a pin which is straight along its entire length. In accordance with the invention, as each row of pins is associated with its own PCB, the need to bend pins may be avoided.

The pin carrier may be of any suitable, electrically insulating, material. The pin carrier is preferably formed from a plastics material. The plastics material may be of any suitable composition, and the most suitable material will depend upon the intended method of manufacture of the device, or at least the PCB assemblies thereof. The plastics material may, in embodiments, be selected such that the plastic remains intact during a heating step of SMT manufacturing used to provide the PCB assemblies.

The pin carrier is preferably a single piece carrier. The pin carrier may be integrally moulded e.g. using an injection moulding process. In some embodiments, the pin carrier may advantageously be formed around the pins.

In embodiments each pin of the pin assembly has a longitudinal axis along which it extends, and the pin carrier extends in a second direction perpendicular to the first direction. In embodiments the row of pins extends along this second direction.

In embodiments the pin carrier is an elongate pin carrier, defining a longitudinal axis along the second direction. In preferred embodiments the pin carrier is in the form of a strip. The row of parallel pins retained by the pin carrier extends along the length of the strip.

In preferred embodiments, the pin carrier is mounted to its respective PCB (other than indirectly through the connection of the individual pins retained by the pin carrier to the PCB).

The pin carrier may comprise one or more protrusion, each protrusion cooperating with a respective one of one or more recesses in the PCB of the PCB assembly of which the pin carrier and PCB form part, so as to mount the pin carrier to the PCB. The protrusion and recess locate the PCB and pin carrier relative to one another. In embodiments, a pair of cooperating protrusions and recesses are provided e.g. associated with each one of the longitudinal ends of the pin carrier. In one exemplary embodiment, each protrusion is a hook or peg, and each recess is a hole through the PCB. The protrusion may extend in the third direction i.e. a direction spacing the rows of pins provided by the first and second PCB assemblies.

While this protrusion and recess embodiment is one arrangement for mounting the pin carrier to the PCB, and provides advantages in terms of ease of assembly, other arrangements may be used within the scope of the present invention. Thus, in embodiments, the pin carrier and the PCB of the PCB assembly of which the PCB and pin carrier form part may comprise respective parts which cooperate with e.g. engage one another to mount the pin carrier to the PCB. A pair of such cooperating parts may be provided, one pair at each longitudinal end of the pin carrier. For example, each PCB may comprise one or more protrusions configured to be received in respective ones of one or more recesses in the respective pin carrier. The pin carrier may be mounted to the PCB using any combination of "mating" features which may be brought into engagement with one another by locating the pin carrier and its respective PCB appropriately relative to one another.

Such arrangements may allow forces applied to the pins in use to be decoupled from the soldered connections, and instead applied to the PCB substrate. As such, the combined use of the soldered connections with an additional mounting i.e. locating feature between the PCB and pin carrier allows the pins to be electrically connected to the PCB in a more robust manner by reducing the amount of tension transmitted from the pins to the soldered connections, in comparison with e.g. an arrangement where the pins are assembled on a per-pin basis.

Any arrangement providing a (direct) connection between the PCB and pin carrier additional to that provided by the (indirect) connection of the pins to the PCB may reduce the amount of tension transmitted from the pins to the soldered connections.

The PCB assemblies may advantageously be assembled using an SMT process. Such processes have a high capacity for automation, and make more efficient use of space on a PCB than through-hole assembly.

In embodiments in which the PCB and pin carrier are mounted to one another e.g. using cooperating protrusion(s) and recess(es), the mounting may be achieved by a pick-and-place machine locating the pin carrier relative to the PCB e.g. such that the protrusion(s) of the pin carrier are received in the recess(es) of the PCB.

Regardless of whether the pin carrier is mounted to the PCB, in embodiments, the pin carrier comprises one or more planar regions configured to be engageable with a suction pad of a pick-and-place machine. Accordingly, in such embodiments, it is possible to more easily locate the pin carrier relative to the PCB during the manufacturing process using a suction based pick-and-place machine, facilitating assembly of the PCB assembly by SMT. The or each planar region may extend along the first and second directions. The or each planar region may define a plane extending in the direction along which the longitudinal axes of the pins of the PCB assembly extends i.e. in the first direction, and in the direction along which the row of pins of the PCB assembly extends i.e. the second direction.

The or each planar region may lie in a plane parallel to a plane in which the axes of the row of pins retained by the pin carrier extend or parallel to a plane defined by the major surface of the PCB. The or each planar region may have a normal pointing in the third direction. The or each planar region may contact a surface of the PCB opposite that to which the pins are soldered. The surface is a major surface.

Each planar region may be provided by a surface of a pad projecting from a proximal edge of the pin carrier.

A pair of planar regions (and, in embodiments, pads) may be provided, one at each longitudinal end of the pin carrier.

The PCB assemblies are located in the OBD device such that the pin contacts provided by the first and second PCB assemblies provide respective ones of the rows of pin contacts of a connector of the OBD device.

The PCBs of the first and second PCB assemblies may be positioned in a stacked arrangement with respect to one another within the device. The PCBs of the first and second PCB assemblies may extend substantially parallel to one another. Such arrangements may provide a more space efficient device. For example, the angle between a normal to the major surface of the PCB of the first PCB assembly and the normal to the major surface of the PCB of the second PCB assembly may be selected from: (i) < 10 degrees; (ii) < 5 degrees; and (iii) < 1 degree.

The PCBs of the first and second PCB assemblies are joined together to retain them in a given position relative to one another. The PCBs may be two distinct PCBs that are subsequently joined together. The joining may use any suitable mechanical connection. The joining may permit some small degree of movement e.g. flexing of the PCBs relative to one another e.g. to accommodate forces applied to the pin contacts in use, which may otherwise tend to cause the pins to flex. This may reduce the risk of pins becoming detached from the PCB. Thus, small deviations from a precisely parallel arrangement of the PCBs may be tolerated.

A suitable electrical connection is provided between the PCBs. This may be provided by the same components which provide a mechanical connection between the PCBs in some embodiments, although this is not necessarily the case.

The connector is located at a distal end of the OBD device. The device may comprise a main body and the connector at a distal end thereof. The OBD device may comprise a connector housing.

The connector housing and each pin carrier may be locked together. This may be achieved using any suitable cooperating formations on the pin carriers and connector housing.

In embodiments, the connector housing comprises first and second slots into which the pin carriers of the first and second pin assemblies respectively are plugged from the proximal side of the housing. A distal face of each pin carrier may close its respective slot. The distal face of the pin carrier thus provides a portion of a face (i.e. a back or proximal face) of the connector. Each pin carrier may be arranged to lock together with the connector housing when inserted through its respective slot.

The connector housing may form part of a housing of the device, the housing comprising a main body housing and a connector housing. The main body housing may e.g. be in the form of a shell. The shell may be made up of a plurality of pieces. The pieces may be arranged to snap fit together.

In embodiments, the OBD device has a first major surface and a second major surface, and the PCB of each PCB assembly has a first major surface closer to the first major surface of the device and a second major surface closer to the second major surface of the device, wherein the pins associated with each one of the PCB assemblies are connected e.g. soldered to a corresponding one of the first and second major surfaces of their respective PCB.

The PCB assemblies may be located within an interior of the OBD device (i.e. within a housing thereof), with only the distal ends e.g. distal portions of the pins exposed to provide the row of pin contacts of the connector.

The OBD device may be elongate having a first dimension and a second dimension, the first dimension being longer than the second dimension. The longitudinal axes of the pins of each pin assembly extend along the first dimension of the OBD device. The PCB of each PCB assembly may be elongate, having a first dimension longer than the second dimension, the first dimension of each PCB extending along the first dimension of the OBD device. The longitudinal axis of each pin of the PCB assembly may extend in the first direction.

It will be appreciated that the connector of the OBD device of the invention in any of its embodiments may be configured to be connected to an OBD port of a vehicle of any construction, whether in accordance with a current or future standard. Thus, the number of rows of pins provided, and/or the number of pins per row, and/or the spacing of the rows and/or the spacing of the pins within the rows may be selected as appropriate.

Preferably the connector of the OBD device has only two rows of pin contacts, one provided by each one of the first and second PCB assemblies. Thus, preferably no further PCB assembly or pins are provided other than the first and second PCB assemblies and their respective rows of pins.

In embodiments, each row of pins may contain 8 pin contacts or less. In embodiments, each row contains at least 3 pin contacts and up to 8 pin contacts. Such an arrangement may provide a pin configuration suitable for cooperating with a standard OBD port e.g. in accordance with ISO 15031 and/or SAE J1962. In some exemplary embodiments, the spacing between the rows of pin contacts may be 8.6mm.

The connector of the OBD device may comprise one or more features to ensure that the connector may only be used with a particular type of OBD port. For example, the OBD device connector may comprise one or more members projecting beyond the distal ends of the pin contacts and which must be received in one or more cooperating slots of an OBD port in order to enable the pins to be inserted into openings of the OBD port. Alternatively or additionally, a connector housing may be configured such that it may only be received by a particular configuration of OBD port to enable the OBD device connector to be plugged into the OBD port with the pin contacts received in openings thereof. Such features may prevent the OBD device being connected to an OBD port of a type with which it is not intended to be used.

In embodiments the pin contacts may be are arranged in accordance with the standard set out in ISO 15031 and/or SAE J1962. The pin contacts may alternatively or additionally be arranged such that they may be received by openings of an OBD vehicle port configured in accordance with the standard set out in ISO 15031 and/or SAE J1962. Alternatively or additionally, the pin contacts of the rows of pins provided by the first and second PCB assemblies can provide the first and second rows of pin contacts required to cooperate with an OBD vehicle port in accordance with the "OBD II" standard. However, in other embodiments, it is envisaged that the pin contacts may also be arranged to engage with other ports which involve two, or two or more rows of pins.

The first and second PCB assemblies may be of the same general construction. However, the number of pins in each row of the OBD device connector may be the same or different. Thus, the number of pin contacts and hence pins of the first and second PCB assemblies may differ. The spacing of the pins in the row of pins of the first or second PCB assembly may be regular or irregular, and the spacing of the pins in the different assemblies may be the same or different. Typically the connector of the OBD port will comprise rows of pin-receiving openings, with each row including the same number of openings, and the openings in each row being regularly spaced. The spacing of the openings in each of the rows may be the same. The OBD device connector may be have pin contacts configured to be received by such pin-receiving opening arrangements.

In some embodiments, the rows of pin contacts provided by the first and second PCB assemblies may each include the same number of pin contacts, optionally with the pin contacts in each row being regularly spaced. The spacing of the pin contacts in each row may be the same. However, it is envisaged that different numbers and/or spacings of pin contacts in the rows of pin contacts provided by the first and second PCB assemblies may be used e.g. where it is not desired to use all the available connections provided by openings in the OBD port. Whatever the number and/or spacing of pin contacts in each row, the axes of the pin contacts in each row are parallel with one another, and the rows of pin contacts may be parallel with one another to enable those pin contacts which are provided to be received by openings of the OBD port when the OBD device is connected to the OBD port.

It will be appreciated that one pin is provided for each pin contact in each of the first and second PCB assemblies. Thus, discussion in relation to the configuration of the pin contacts may apply equally to the pin contacts, and vice versa, unless the context demands otherwise.

The first and second PCB assemblies are distinct assemblies, although may be electrically and mechanically joined to one another. The pins, PCB and pin carrier of each PCB assembly are not shared between the assemblies.

The PCBs of the device may comprise any desired circuitry. The circuitry of a PCB may be arranged to provide a set of one or more processors for implementing any desired functionality of the device. The circuitry may be distributed between the PCBs as desired, to distribute functionality therebetween.

In embodiments, the PCBs of the first and second PCB assemblies are arranged such that their opposed major surfaces are spaced from one another. This may help to avoid interference between circuitry provided on each PCB. Different RF circuits which may be liable to interfere with one another may be provided using the circuitry of different ones of the PCBs of the first and second PCB assemblies to reduce the risk of interference between the circuits. The present invention enables the functionality to be split between two PCBs, enabling space to be saved, and providing the ability to decouple different RF systems from another.

In some embodiments, the first PCB assembly comprises a first RF circuit and the second PCB assembly comprises a second RF circuit that is different to the first RF circuit. The first and second RF circuits may be selected from a cellular modem circuit, an RF antenna circuit, a Global Navigation Satellite Systems (GNSS) circuit, a Bluetooth circuit, or a vehicle bus transceiver circuit.

The device may be arranged to obtain data from a vehicle system when plugged into an OBD port, and optionally to transmit output data based thereon over a wireless communications interface e.g. to a server. The OBD device may be an OBD dongle. The OBD device may provide a vehicle telematics device. Such devices are used in various contexts e.g. vehicle fleet management.

According to another aspect the present invention provides a method of using the OBD device of any of the forgoing embodiments. The method may comprise plugging the connector of the device into an OBD port of a vehicle and using the device to obtain data from the vehicle via the OBD port. The method may comprise the OBD device transmitting output data based on the obtained data over a wireless communications interface e.g. to a server. This may be performed as part of the implementation of a vehicle telematics system. The device may be arranged to process the obtained data in order to provide the output data. For example, the output data may be a metric for driving economy, produced by processing data relating to the engine, steering, and braking data collected over a driving session. However, other types data may be obtained from the vehicle, and/or other types of output data may be obtained by processing this data.

According to a further aspect the present invention also provides a method of manufacturing an OBD device in accordance with any one of the embodiments described herein. The method may involve providing any of the features of the device described herein.

The method may comprise obtaining the first PCB assembly and the second PCB assembly. Obtaining each PCB assembly may comprise providing a PCB for the PCB assembly, and providing the pin assembly for the PCB assembly. The method may comprise; placing solder paste on the PCB for the PCB assembly; locating the pin assembly relative to the PCB using a pick-and-place machine such that solder paste is positioned between at least an end of each of the pins of the pin assembly and the PCB; and heating the PCB and the pin assembly, such that the solder paste between the at least an end of each of the pins forms a soldered connection bonding the at least an end of the pin to the PCB.

The heating step provides a solder reflow step. The heating step causes solder particles in the solder paste to melt, bonding the at least an end of each of the pin to the PCB. In this step the previously deposited solder paste is caused to reflow to bond the pin to the PCB. The heating may be achieved in any suitable manner e.g. based on infrared heating, convection, or vapour phase reflow. The heating may be performed in a reflow soldering oven. Prior to the heating step, the solder paste may temporarily attach the pin to the PCB. The end of each of the pins corresponds to the proximal end of the pins of the OBD device.

The method may comprise conveying the PCB (e.g. using one or more conveyor) along an assembly line sequentially to a pick-and-place machine operating region and then to a heating region e.g. a reflow soldering oven.

The PCB assemblies may be obtained simultaneously or sequentially.

The method is an SMT process. The heating step provides a reflow phase of the process. In general an SMT process involves applying solder paste to intended solder locations i.e. solder pads of a PCB e.g. using a printing process, and then providing the PCB to an assembly line in which the components of the PCB are deposited on the solder locations using a pick-and-place machine. The PCB with the components deposited thereon is then conveyed to a reflow soldering stage in which the PCB and the components deposited thereon are heated to melt solder particles in the solder paste to bond the components to the PCB.

In embodiments in which the pin carrier comprises a planar region configured to be engageable with a suction pad of a pick-and-place machine, the pick-and-place machine may pick up the pin carrier using the planar region i.e. by applying suction to the planar region.

In accordance with the invention the solder paste is placed on the PCB at least in locations corresponding to the locations at which the pins of the pin carrier are to be soldered thereto. Solder paste may be applied to the PCB in a plurality of discrete locations corresponding to the intended soldering location of each pin. Each such location may correspond to a soldering pad of the PCB. Solder paste may also be applied in other locations where required for the connection of other components of the PCB. These locations may be the locations of respective soldering pads in respect of the other components. The solder paste locations for the pins and/or any other components to be soldered may be marked using a paste mask. The paste mask may control the location and amount of solder paste to be deposited. The solder paste may be deposited using any suitable process e.g. a printing process, such as screen or ink jet printing.

As described in relation to the pins, the solder paste may temporarily attach the other components to the PCB. The other components may be bonded to the PCB along with the pins during the heating step. Thus, the heating step may provide a reflow phase of the process for all components to be soldered to the PCB, including the pins.

The method may comprise locating one or more, and preferably a plurality of, other components of the PCB relative to the PCB using a pick-and place machine, such that solder paste is positioned between each component and the PCB. The heating step may then provide a soldered connection between the at least a proximal end of each of the pins and the PCB, and simultaneously, between each of the other components of the PCB and the PCB. The soldered connection bonds the pin or other component to the PCB. The components of the PCB are components for providing circuitry thereof.

It will be appreciated that the pins (and, where applicable, other components) are connected to a PCB for the PCB assembly. The PCB, prior to connection of the pins (and, where applicable, other components), may be considered to be in a semi-assembled state, in that the pins, (and, where applicable, other components) have yet to be connected thereto. The connection of the pins, and where appropriate, other components, forms part of the assembly of the PCB, and may complete assembly of the PCB.

The method may comprise, where the pin carrier comprises features to facilitate mounting of the pin carrier to the PCB e.g. a protrusion which cooperates with a recess e.g. hole, mounting the pin assembly to the PCB using the mounting features e.g. locating the pin assembly relative to the PCB with the protrusion e.g. hook or peg of the pin carrier engaged within the recess e.g. hole. This may locate the pin carrier relative to the PCB such that the pins will engage the solder paste when located thereon. The mounting may be performed using the pick- and-place machine.

It will be appreciated that the same or different pick-and -place machine may be used to deposit each pin carrier on its respective PCB and/or to deposit the various other components on the PCB. In general, the pin carriers, and, where applicable, other components, are applied to the PCB using a pick- and-place process. Thus, references to the use of a pick-and-place machine may be replaced by a reference to the use of a pick-and-place process. Such a process may involve the use of one or more pick-and-place machine.

The use of an SMT manufacture method rather than through-hole assembly is advantageous as described above, and enables the pins of the pin assembly to be connected to the PCB at the same time as other components are connected to the PCB. The need to provide a dedicated step for joining the pin assembly to the PCB is avoided.

The method may further comprise the additional steps of joining the first PCB assembly to the second PCB assembly; and positioning the first and second PCB assemblies relative to (e.g. at least partially within) a housing of the OBD device with the PCB assemblies located in a manner such that the rows of parallel pin contacts provided by the first and second PCB assemblies respectively provide respective ones of rows of parallel pin contacts of a connector of the OBD device.

The joining may involve providing any suitable mechanical connection. The joined PCB assemblies provide a unit which may be handled as one to position the PCB assemblies within the housing. The method may also comprise providing an electrical connection between the first and second PCB assemblies.

The connector housing and each pin carrier may be locked together. This may be achieved using any suitable cooperating formations on the pin carriers and connector housing. The pin carrier of each PCB assembly may comprise one or more locking hooks which cooperate with the connector housing for locking the pin carrier thereto.

The housing of the device may comprise a main body housing and a connector housing. The main body housing may e.g. be in the form of a shell. The shell may be made up of a plurality of pieces. The pieces may be arranged to snap fit together.

In embodiments the housing comprises a connector housing and the step of positioning the first and second PCB assemblies within the housing comprises inserting the rows of parallel pin contacts provided by each of the first and second PCB assemblies through respective slots in a connector housing for the device.

In embodiments the connector housing comprises first and second slots, and the method comprises plugging the pin carriers of the first and second pin assemblies respectively into the first and second slots from the proximal side of the connector housing. A distal face of each pin carrier may close its respective slot. The distal face of the pin carrier thus provides a portion of a face (i.e. a back or proximal face) of the connector. Each pin carrier may be arranged to lock together with the connector housing when inserted through its respective slot.

The method may comprise positioning the first and second PCB assemblies relative to the connector housing before providing a main body of the housing.

The method may comprise forming each pin assembly by integrally moulding the pin carrier around the pins. The method may comprise forming the pin carrier around the pins by placing the pins in a mould, placing a fluid plastics material in the mould, and solidifying the plastics material around the pins.

While it might be conventionally understood that using two PCBs may incur additional costs and complexity, the Applicant recognises that when the PCBs are associated with respective pin assemblies in accordance with the present invention, this arrangement can be used to form a device which has a lower manufacturing cost and reduced spatial requirements in comparison with a conventional pin-header device arrangement, and which is more robust and more straightforward to manufacture than a conventional arrangement in which the pins are each mounted independently on a per-pin basis.

The present invention in accordance with any of its aspects or embodiments may include any of the features described in reference to other aspects or embodiments of the invention to the extent it is not mutually inconsistent therewith.

### BRIEF DESCRIPTION OF THE FIGURES

Various arrangements and embodiments will now be described, by way of example only, and with reference to the accompanying drawings, in which:
FIGURE 1 shows an example of a device comprising a pin header (and is a simplified schematic view exemplifying certain features of the device);
FIGURE 2A shows a view of a device comprising a row of individually mounted pins which are each inserted into a hole in a PCB (and is a simplified schematic view exemplifying certain features of the device);
FIGURE 2B shows a view of another device comprising a row of individually mounted pins (and is a simplified schematic view exemplifying certain features of the device);
FIGURE 3 is a perspective view showing an OBD device according to an embodiment of the invention with the housing removed for ease of illustration;
FIGURE 4A shows pin assemblies of the first and second PCB assemblies, according to the embodiment of Figure 3;
FIGURE 4B is a vertical cross sectional view of the pin assembly of the second PCB assembly of Figure 4A;
FIGURE 5A illustrates schematically one way in which pegs of a pin carrier may be received in holes in a PCB in accordance with an embodiment of the invention;
FIGURE 5B illustrates the first PCB assembly according to the embodiment of Figure 3;
FIGURE 5C shows the second PCB assembly of the embodiment of Figure 3;
FIGURE 6A shows certain components which facilitate the connection of the PCB of the first PCB assembly to the PCB of the second PCB assembly, according to an embodiment;
FIGURE 6B shows the PCB of the first PCB assembly shown in Figure 6A connected to the PCB of the second PCB assembly shown in Figure 6A;
FIGURE 7 is an exploded view illustrated one way in which a connector housing may be configured to engage with the first and second PCB assemblies according to an embodiment;
FIGURE 8A is a perspective view of the OBD device according to the embodiment of Figure 3 with the housing illustrated;
FIGURE 8B is another view of the OBD device of Figure 8A from the connector end;
FIGURE 9 shows a flow chart for a method of manufacturing the OBD device, according to an embodiment; and
FIGURE 10 shows a flow chart for a method of using the OBD device, according to an embodiment.

### DETAILED DESCRIPTION

FIGURE 3 is a schematic diagram of an OBD device 100 according to an embodiment of the present disclosure with the housing removed for ease of illustration. The device comprises a first PCB assembly 110 and a second PCB assembly 120. The reference numerals of the corresponding parts of the first and second PCB assemblies 110,120 will be referred to one after the other after the relevant component has been mentioned, with the reference numeral in respect of the first PCB assembly mentioned first.

Each one of the first and second PCB assemblies 110, 120 comprises a PCB 112, 122 having major surfaces 113, 123 suitable for implementing circuitry components thereon. The PCBs 112, 122 are positioned in a stacked arrangement, such that major surfaces 113, 123 of the PCB 112 of the first PCB assembly 110 and the PCB 122 of the second PCB assembly 120 face one another.

Each PCB assembly 110, 120 comprises a pin assembly 114, 124, mounted to its respective PCB 112, 122. Each pin assembly 114, 124 comprises a pin carrier 116, 126 in the form of a plastic strip. Each pin assembly 114, 124 also comprises a row of pins 118, 128, which are retained by the respective pin carrier 116, 126. Each of the pins 118, 128 has a longitudinal axis along which it extends, and the pins 118, 128 of each pin assembly 114, 124 are retained by the pin carrier 114, 124 so as to be arranged in parallel, such that the longitudinal axis of all the pins 118, 128 in the pin assembly 114, 124 are aligned in a first direction 10. The first direction 10 is substantially perpendicular to a second direction 20 in which each row of pins 118, 128 extends.

As well as the pin assemblies 114, 124, circuitry components e.g. 117, 127 are also implemented on the PCBs 112, 122. These circuitry components implemented on the PCBs 112, 122 may include, but are not limited to, a power regulator, a battery, a charging circuit, a cellular modem, an antenna, a microprocessor, memory, a Global Navigation Satellite Systems (GNSS) circuit, a Bluetooth circuit, one or more vehicle bus transceiver circuits, and an acceleration sensor. Various particular circuitry components (e.g. the GNSS circuit) act as RF systems. These particular circuitry components can be arranged on the PCBs to maximise the distance between one another, allowing the interference between different RF systems to be reduced. The distance between the first and second PCBs 112, 122 can help reduce interference between these RF systems, in comparison with an arrangement where all the RF systems are arranged on one PCB.

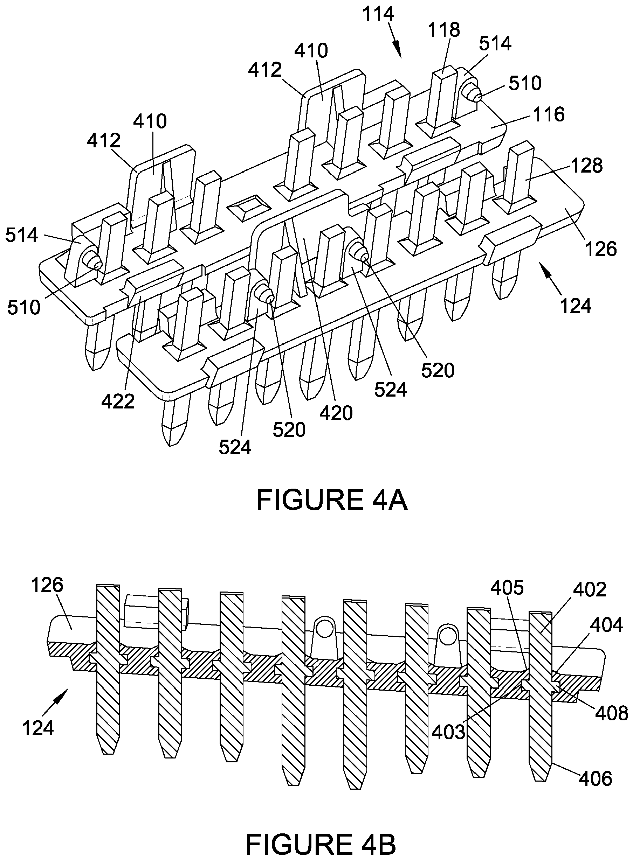

FIGURE 4A shows the pin assemblies 124 and 114 in more detail. A cross section taken through the pin assembly 124 of the second PCB assembly 120, along the line A-A is shown in Figure 4B. However, the features shown in the cross section in Figure 4B can equally be applied in the pin assembly 114 of the first PCB assembly 110. As shown in Figures 4A and 4B, an intermediate portion 404 of each pin 118, 128 is retained within and encapsulated by the pin carrier 116, 126 to which it is connected, as shown in Figures 4a and 4b. In other words, the intermediate portion 404 of each pin extends through a respective bore 405 of the pin carrier 116, 126. This intermediate portion 404 of each pin 118, 128 comprises a projection 408, which is received by a cooperating recess 403 in the bore 405 of the pin carrier 116, 126, thereby allowing the pin 118, 128 to be firmly secured within the pin carrier 116, 126, and inhibiting longitudinal movement of the pin 118, 128 relative to the pin carrier 116, 126.

The pins 118, 128 are substantially straight, such that they do not include any bends, and in addition to the intermediate encapsulated portion 404, each pin 118, 128 includes a proximal portion 402 extending from one side (a proximal side) of the pin carrier 116, 126 by which it is retained. The proximal portion 402 of the pin 118, 128 is electrically connected with a soldered connection to the PCB 112, 122. Each pin 118, 128 also includes a distal portion 406, extending from the opposing side of the pin carrier 116, 126 to the proximal portion 404 (i.e. the distal side).

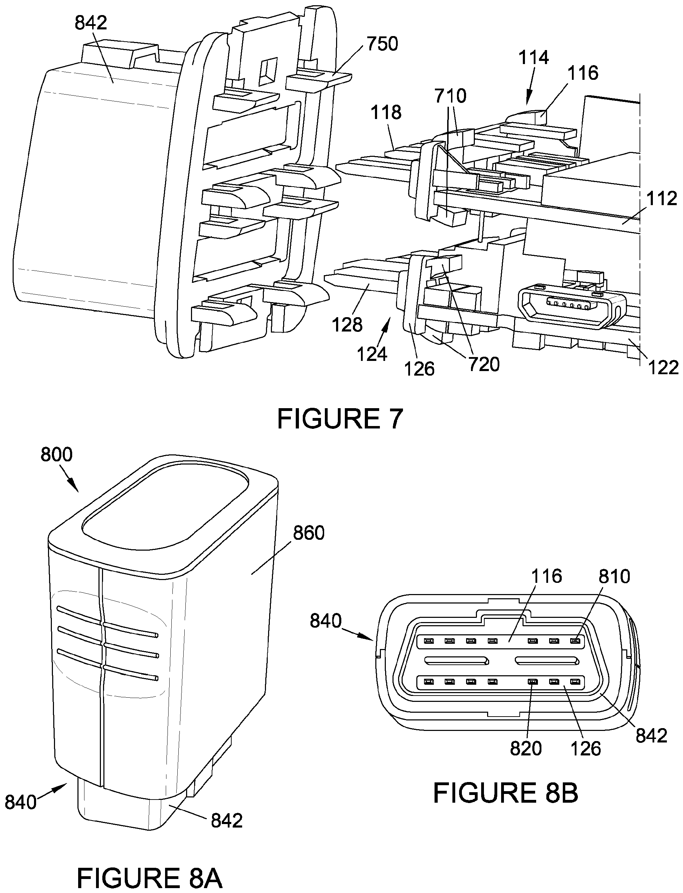

As shown in Figure 8A, which shows the OBD device 100 with its housing, the OBD device 100 comprises a housing 800, within which the PCB assemblies are retained. The housing 800 comprises a connector housing 842, which extends in the first direction and a portion of which is configured to be received by a complementary slot in an OBD port. At least part of the distal portion 404 of each pin 118, 128 extends beyond a back face of the connector housing 802, providing a pin contact. The housing 800 also comprises a main housing part 860, which surrounds the remainder of the PCB assemblies 110, 120.

The row of pins 118 connected to the PCB 112 of the first PCB assembly 110 provides a first row of pin contacts 810 of a connector 840 of the OBD device 100, and the row of pins 128 connected to the PCB 122 of the second PCB assembly 120 comprises a second row of pin contacts 820 of the connector 840. These two rows of pin contacts 810, 820 are positioned such that the pin contacts 810, 820 may be received by openings in an OBD port. In the illustrated embodiment, these pin contacts are arranged in accordance with the standards set out in ISO 15031 and SAE J1962. As such, each row contains up to 8 pin contacts 810, 820, although each row may contain less according to the signals and functions required. The rows of pin contacts 810, 820 may have different numbers of pins. As each of the pin connections in an OBD port is only required for particular functions, it is not always necessary to provide the maximum 16 pin contacts, depending on the functionality implemented on the PCBs. The first and second rows of pin contacts 810, 820 are substantially parallel to one another, and may, in one exemplary embodiment, be arranged 8.6mm apart from one another.

As shown in Figure 4A, each pin carrier 116, 126 is in the form of a strip, extending in the second direction 20. Each pin carrier 116, 126 also comprises one or more pads 410, 420, each pad 410, 420 defining a planar region 412, 422, which provide a surface for a pick-and-place machine to suction on to. When each pin assembly 114, 124 is mounted to the respective PCB 112, 122, each planar region 412, 422 has a normal to its surface pointing in the third direction 30.

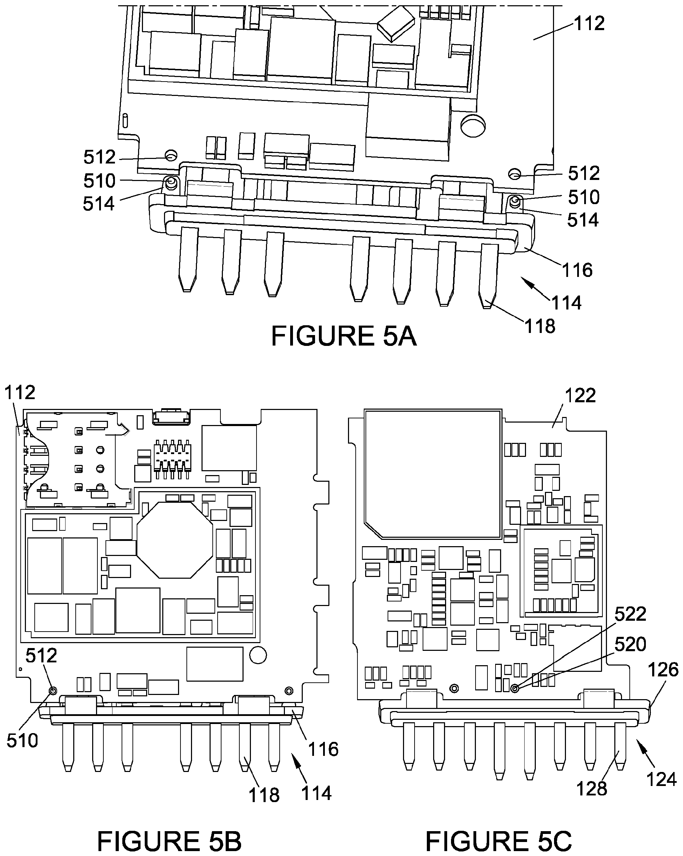

As discussed above, each pin in a row of pins 118, 128 provided by one of the first or second PCB assemblies 110, 120 is electrically connected at a proximal portion to a PCB 112, 122 by a soldered connection. In order to provide additional support to the connection between each pin assembly 114, 124 and the respective PCB 112, 122, each pin carrier 116, 126 also comprises pegs 510, 520 which are received by respective holes 512, 522 in the PCB 112, 122, as shown in Figure 5A, which shows an exploded view of the PCB 112 and pin assembly 114 of the first PCB assembly 110. These pegs 510, 520 allow forces applied to the pins 118, 128 to be decoupled from the soldered connections, and instead applied to the PCB material via the pegs 510, 520. The pegs 510 of the first pin carrier 116 are positioned differently to the pegs 520 on the second pin carrier 126, as a result of the differing circuitry implemented on each of the PCBs.

FIGURE 5B shows the first PCB assembly 110, with the pin assembly 114 mounted to the PCB 112, and the pegs 510 of the pin carrier 116 being received by the holes 512 in the PCB 112. Figure 5C correspondingly shows the second PCB assembly 120, with the pin assembly 124 mounted to the PCB 122, and the pegs 520 of the pin carrier 126 being received by the holes 522 in the PCB 122.

In the embodiment shown in Figures 5A, 5B, and 5C, each pin carrier 116, 126 of the first and second PCB assemblies 110, 120 comprises two pegs 510, 520 which are connected to an extending portion 514, 524 of the pin carrier 116, 126 which overlaps the footprint of the PCB 112, 122 to which its pins 118, 128 are connected. The pegs 510, 520 extend in a third direction 30, different to the first and second directions 10, 20, and are received by holes 512, 522 in the PCB 112, 122. This third direction 30 is perpendicular to the first direction 10 and second direction 20.

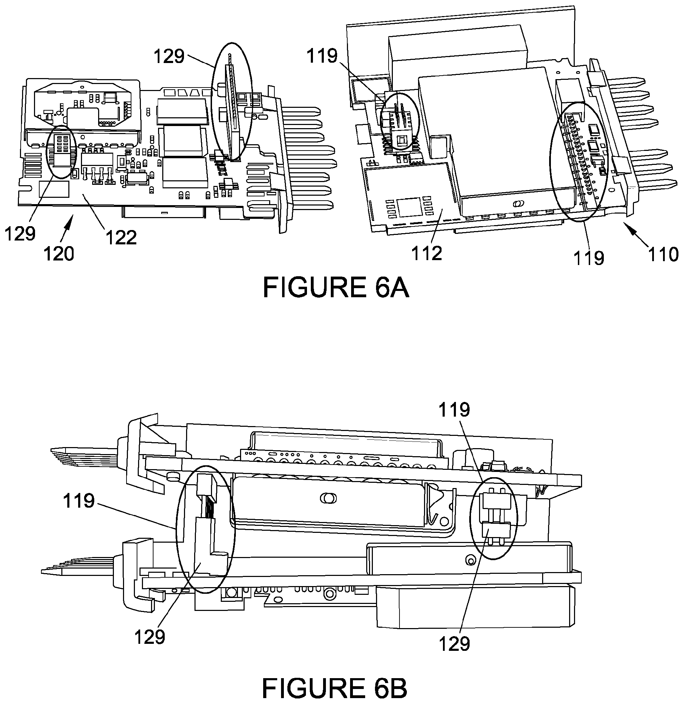

As shown in Figures 6A and 6B, the first and second PCB assemblies 110, 120 are mechanically joined to one another, and electrical communication means is provided between the two. The first and second PCB assemblies can be connected to one another using connection components 119 implemented on the first PCB 112, and connection components 129 implemented on the second PCB 122. Figure 6A shows the first and second PCB assemblies 110, 120 separate from one another, each having mounted thereon respective connection components 119, 129 which are configured to engage with one another to facilitate a connection between the first and second PCB assemblies 110, 120. The components may mate with one another. Each PCB assembly is depicted having circuitry mounted thereon for the purpose of illustration only, and which happens to comprise different components to the circuitry shown in the preceding Figures. The mechanical joining of the PCB assemblies 110, 120 is such that there is some play in the distance and parallelism of the PCB assemblies 110, 120. In other words, the distance and parallelism of the PCB assemblies 110, 120 may vary while the connection components 119, 129 continues to provide an electrical and mechanical connection between the first and second PCB assemblies 110, 120. In the embodiment illustrated, this may be achieved through sliding of the components 119, 129 relative to one another. This can allow the device to accommodate any slight difference in alignment of the pin assemblies 114, 124 with respect to the PCBs 112, 122. Thus, when the device 100 is plugged into a vehicle's OBD port, the PCB assemblies 110, 120 can be realigned by the engagement of the pin contacts 810, 820 with the slots in the OBD port in which they are received, without tension on the pin soldering points. Such tension is undesirable, as it is possible for tin to flow under static pressure, meaning that a soldering connection under tension may be mechanically unreliable.

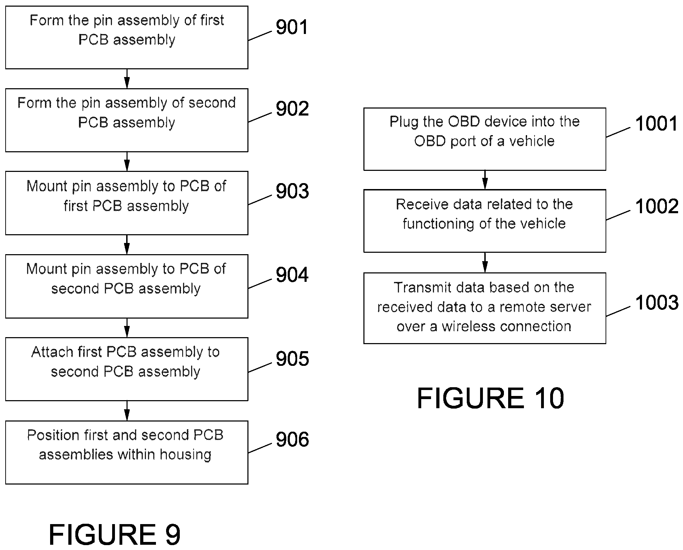

FIGURE 9 shows a method of manufacturing the OBD device according to an embodiment of the present invention. Step 901 comprises forming the pin assembly of the first PCB assembly, and step 902 comprises forming the pin assembly of the second PCB assembly. Each pin assembly is advantageously formed using insert injection moulding. This process involves placing a component or components (in this case, the row of pins 118, 128) within a mould cavity, which is then filled with in a softened or molten material. The softened or molten material then solidifies (in this case forming the pin carrier 116, 126), and the combined assembly (in this case the pin assembly 114, 124) is removed from the mould. Step 901 may be performed concurrently with step 902, for example in a common mould, or the two steps may be performed at different times.

Insert injection moulding is a process which has a high potential for automation. Additionally, in the case of the pin assemblies 114, 124 of the present invention, the insert injection mould tool can be loaded with various numbers of pins 118, 128 without irreversible tool change, according to the signals and functions to be derived by the device from the OBD port. For example, there may be no need to change the shape of the mould used for different numbers of pins 118, 128. The mould may have plural predefined locations for receiving pins 118, 128 at regular spacing along its length, which are either used (i.e. used to receive a pin) or are not used.

Step 903 comprises mounting the pin assembly 114 formed in step 901 to a PCB 112 to form the first PCB assembly 110. Step 904 comprises mounting the pin assembly 124 formed in step 902 to a PCB 122 to form the second PCB assembly 120. These steps may be performed simultaneously or sequentially, and both involve the multi-stage mounting process SMT. First, solder i.e. soldering paste (e.g. including tin and flux) is applied to solder pads on a PCB, at locations where electrical connections are to be subsequently formed. Using a pick-and-place machine, a pin assembly 114, 124 is then placed on the PCB, such that the pegs 510, 520 of the pin assembly 114, 124 are received by the holes 512, 522 in the PCBs, and the pins 118, 128 form connections with the solder placed on the solder pads. As discussed above, each pin assembly 114, 124 provides one or more planar regions 412, 422, which a pick-and-place machine may suction on to, allowing the pick and place machine to move the pin assembly 114, 124 onto the respective PCB 112, 122. In addition to a pin assembly 114, 124, the components placed on the PCBs 112, 122 may include any of the additional components discussed above.

The PCB 112,122, is then heated in an oven along with the components placed thereon. The temperature in the oven is sufficiently high to melt the solder, and bond the components to the PCB, in a process referred to as "reflow soldering". The heating step may be applied to both the first and second PCB assemblies 110, 120 at the same time, or alternatively they may be heated separately. In these embodiments, the plastic material which the pin carriers are formed from should be constructed from a suitable material, e.g. a plastic which is able to withstand the steps of the SMT process, in particular the step of heating.

Because the soldered connection between the pins 118, 128 and the respective PCB 112, 122 can be formed simply by placing the pin assembly 114, 124 in position on the respective PCB 112, 122 with solder i.e. solder paste between the pins 118, 128 and the PCB 112, 122, and subsequently heating the solder, and because the locating of the pin carrier 116, 126 with the respective PCB 112, 122 may be achieved simply by placing the pegs 510, 520 of the pin carrier 116, 126 into the openings 512, 522 in the PCB 112, 122, it is possible to install all of the components, most notably the pin assembly, onto the respective PCB using SMT with a pick-and-place machine. The pin assembly may be soldered to the PCB at the same time as other components that have been deposited thereon in the pick-and-place process by locating the PCB with all the components disposed thereon in the oven. As such, each component can be mounted using SMT, and it not necessary to use another additional mounting method such as through-hole mounting.

In step 905, having been assembled, the first and second PCB assemblies 110 and 120 are mechanically joined to one another. In step 906, the mechanically joined first and second PCB assemblies 110, 120 are then inserted together into connector housing 842, by inserting the pin carriers 116, 126 into corresponding slots in the connector housing 842. In embodiments, the PCB assemblies 110, 120 are inserted together into the slots in the housing part and are secured by locking into engagement with receiving portions 750 in the connector housing 842, as shown in Figure 7. The pin carriers 116, 126 may comprise one or more hooks 710, 720, which lock into engagement with receiving portions 750 of the connector housing 842. The main housing part 860 is then also connected, to completely house the remainder of the PCB assemblies 110, 120.

FIGURE 10 shows a method of operating the OBD device, according to an embodiment of the present invention. The circuitry distributed across the PCBs may provide a set of one or more processors enabling the OBD device to perform functions required in a vehicle telematics systems. In step 1001, the OBD device is plugged into the OBD port of a vehicle. Then, in step 1002, the OBD device receives data related to the functioning of the vehicle. This data may then be stored, analysed, or otherwise processed by the OBD device. In step 1003, data based on the received data is transmitted to a remote server over a wireless connection.

While the forgoing embodiments are disclosed in the context of an OBD connector, the present invention is not limited to that arrangement alone. The features of the first and second PCB assemblies 110, 120 of the present invention may be applied to any connector having two or more rows of pins, and any such device would also benefit from the advantages of the present invention discussed above.

## Claims

1. A sub-assembly for an On-Board Diagnostics (OBD) device (100) configured to be connected to an OBD port of a vehicle in use, the sub-assembly comprising:
a first PCB assembly (110); and
a second PCB assembly (120);
wherein each one of the first and second PCB assemblies (110,120) comprises:
a PCB (112,122); and
a pin assembly (114,124), the pin assembly (114,124) comprising:
a pin carrier (116,126); and
a row of parallel pins (118,128) retained by the pin carrier (116,126), wherein each pin of the row of pins (118,128) comprises a proximal portion (402) extending from one side of the pin carrier (116,126), at least a proximal end of the pin being connected to the PCB (112,122), and a distal portion (406) extending from an opposite side of the pin carrier (116,126) for providing a pin contact of the device, wherein the row of parallel pins (118,128) retained by the pin carrier (116,126) provides a row of parallel pin contacts (810,820);
wherein the first and second PCB assemblies (110,120) are located relative to one another to enable the rows of parallel pin contacts provided by the first and second PCB assemblies (110,120) respectively to provide respective ones of rows of parallel pin contacts (810,820) of a connector of the device in use, the pin contacts (810,820) being arranged so as to be receivable by openings of an OBD port when the OBD device (100) is connected to an OBD port of a vehicle.

2. The sub-assembly of claim 1, wherein the first PCB assembly (110) and the second PCB assembly (120) are joined to one another, optionally wherein the PCBs (112,122) of the first and second PCB assemblies (110,120) are joined together using first and second parts (119,129) which may slide relative to one another over a given distance while still maintaining an electrical and mechanical connection between the assemblies (110, 120).

3. An On-Board Diagnostics (OBD) device (100), configured to be connected to an OBD port of a vehicle in use, comprising the sub-assembly of claim 1 or 2.

4. The sub-assembly or device (100) of any preceding claim, wherein the pins (118,128) are straight.

5. The sub-assembly or device (100) of any preceding claim, wherein the pin contacts (810,820) of the connector are arranged in accordance with ISO 15031 and/or wherein each row of pins (118,128) contains 8 pin contacts (810,820) or less.

6. The sub-assembly or device (100) of any preceding claim, wherein in each one of the first and second PCB assemblies (110,120):
each pin (118,128) has a longitudinal axis along which it extends, and the longitudinal axes of each pin in the row of parallel pins (118,128) are aligned in a first direction (10); and
the row of parallel pins (118,128) extends in a second direction (20) perpendicular to the first direction (10), and optionally wherein
the rows of pins (118,128) provided by the first and second PCB assemblies (110,120) are spaced from one another in a third direction (30), perpendicular to the first (10) and second (20) directions.

7. The sub-assembly or device (100) of any preceding claim, wherein each pin extends through a bore (405) in the pin carrier (116,126) by which it is retained, the bore (405) comprising one or more recesses (403), and each pin (118,128) comprises an intermediate portion (404) which is located within the bore (405) of the pin carrier, the intermediate portion (404) of the pin comprising one or more protrusions (408), each protrusion (408) cooperating with a recess (403) of the bore (405) of the carrier (116,126) through which the pin extends, to retain the pin (118,128) in position relative to the pin carrier (116,126).

8. The sub-assembly or device (100) of any preceding claim wherein the pin carrier (116,126) is a single piece pin carrier (116,126), and/or
wherein the pin carrier (116,126) is integrally moulded, optionally wherein the pin carrier (116,126) has been integrally formed around the pins (118,128), and/or
wherein the pin carrier (116,126) is in the form of a strip.

9. The sub-assembly or device (100) of any preceding claim, wherein:
the pin carrier (116,126) comprises one or more protrusions (510, 520), each protrusion (510, 520) cooperating with a respective one of one or more recesses (512,522) in the PCB (112,122) of the PCB assembly (110,120) of which the pin carrier (116,126) and PCB (112,122) form part, so as to mount the pin carrier (116,126) to the PCB (112,122), optionally wherein each protrusion is a hook or peg (510, 520), and each recess is a hole (512,522) through the PCB (112,122).

10. The sub-assembly or device (100) of any preceding claim, wherein the pin assembly (114,124) comprises one or more planar regions (412, 422) configured to be engageable with a pick-and-place machine.

11. The sub-assembly or device (100) of any preceding claim, wherein the PCBs (112,122) of the first and second PCB assemblies (110,120) are positioned in a stacked arrangement with respect to one another.

12. A method of using the device (100) of any of claims 3 to 11, comprising:
connecting the device to an OBD port of a vehicle; and
using the device (100) to obtain data from the vehicle via the OBD port, optionally wherein the method further comprises the device (100) transmitting output data based on the obtained data over a wireless communications interface, optionally to a server.

13. A method of manufacturing an OBD device (100) in accordance with any one of claims 3 to 11, comprising:
obtaining the first PCB assembly (110) and the second PCB assembly (120), wherein obtaining each PCB assembly (110,120) comprises:
placing solder paste on a PCB (112,122) for the PCB assembly (110,120);
locating the pin assembly (114,124) relative to the PCB (112,122) using a pick-and place machine such that solder paste is positioned between at least an end of each of the pins (118,128) of the pin assembly (114,124) and the PCB (112,122); and
heating the PCB (112,122) and the pin assembly (114,124), wherein the solder paste between the at least an end of each of the pins (118,128) and the PCB (112,122) forms a soldered connection bonding the at least an end of the pin to the PCB (112,122); and
optionally further comprising: applying solder paste to the PCB (112,122) in other locations for the connection of a plurality of other components to the PCB (112,122), locating the other components of the PCB (112,122) relative to the PCB (112,122) using a pick-and place machine, wherein solder paste is positioned between each component and the PCB (112,122), and bonding the other components to the PCB (112,122) along with the pins during the heating step.

14. The method of claim 13, further comprising the additional steps of:
joining the first PCB assembly (110) to the second PCB assembly (120);
providing a housing (800) for the OBD device (100), optionally wherein the housing (800) comprises a connector housing (842) and the method comprises inserting the rows of parallel pin contacts (810, 820) provided by each of the first and second PCB assemblies (110,120) through respective slots in the connector housing (842) for the device;
and positioning the first and second PCB assemblies (110,120) relative to the housing (800) with the PCB assemblies (110,120) located in a manner such that the rows of parallel pin contacts (810,820) provided by the first and second PCB assemblies (110,120) respectively provide respective ones of rows of parallel pin contacts (810,820) of a connector of the OBD device (100).

15. The method of any one of claims 13 or 14:
further comprising providing the pin assembly (114,124), wherein the step of providing the pin assembly (114,124) comprises forming the pin assembly (114,124) by integrally moulding the pin carrier (116,126) around the pins.

## Patentansprüche

1. Unterbaugruppe für eine bordeigene Diagnose- (OBD) Vorrichtung (100), die dazu konfiguriert ist, mit einem OBD-Anschluss eines Fahrzeugs in Verwendung verbunden zu werden, wobei die Unterbaugruppe Folgendes umfasst:
eine erste PCB-Baugruppe (110); und
eine zweite PCB-Baugruppe (120);
wobei sowohl die erste als auch die zweite PCB-Baugruppe (110,120) Folgendes umfasst:
eine PCB (112,122); und
eine Stiftbaugruppe (114,124), wobei die Stiftbaugruppe (114,124) Folgendes umfasst:
einen Stiftträger (116,126); und
eine Reihe paralleler Stifte (118,128), die von dem Stiftträger (116,126) gehalten werden, wobei jeder Stift der Reihe von Stiften (118,128) einen proximalen Abschnitt (402), der sich von einer Seite des Stiftträgers (116,126) erstreckt, wobei mindestens ein proximales Ende des Stifts mit der PCB (112,122) verbunden ist, und einen distalen Abschnitt (406), der sich von einer entgegengesetzten Seite des Stiftträgers (116,126) erstreckt, um einen Stiftkontakt der Vorrichtung bereitzustellen, umfasst, wobei die Reihe paralleler Stifte (118,128), die von dem Stiftträger (116,126) gehalten wird, eine Reihe paralleler Stiftkontakte (810,820) bereitstellt;
wobei sich die erste und die zweite PCB-Baugruppe (110,120) relativ zueinander befinden, um den Reihen paralleler Stiftkontakte, die von der ersten beziehungsweise der zweiten PCB-Baugruppe (110,120) bereitgestellt werden, zu ermöglichen, jeweilige Reihen paralleler Stiftkontakte (810,820) eines Verbinders der Vorrichtung in Verwendung bereitzustellen, wobei die Stiftkontakte (810,820) so angeordnet sind, dass sie durch Öffnungen eines OBD-Anschlusses aufgenommen werden können, wenn die OBD-Vorrichtung (100) mit einem OBD-Anschluss eines Fahrzeugs verbunden wird.

2. Unterbaugruppe nach Anspruch 1, wobei die erste PCB-Baugruppe (110) und die zweite PCB-Baugruppe (120) miteinander verbunden sind, wobei optional die PCBs (112,122) der ersten und der zweiten PCB-Baugruppe (110,120) unter Verwendung erster und zweiter Teile (119,129) miteinander verbunden sind, die relativ zueinander über eine gegebene Distanz gleiten können, während sie eine elektrische und mechanische Verbindung zwischen den Baugruppen (110,120) aufrechterhalten.

3. Bordeigene Diagnose- (OBD) Vorrichtung (100), die dazu konfiguriert ist, mit einem OBD-Anschluss eines Fahrzeugs in Verwendung verbunden zu werden, wobei sie die Unterbaugruppe nach Anspruch 1 oder 2 umfasst.

4. Unterbaugruppe oder Vorrichtung (100) nach einem vorstehenden Anspruch, wobei die Stifte (118,128) gerade sind.

5. Unterbaugruppe oder Vorrichtung (100) nach einem vorstehenden Anspruch, wobei die Stiftkontakte (810,820) des Verbinders in Übereinstimmung mit ISO 15031 angeordnet sind und/oder wobei jede Reihe von Stiften (118,128) 8 Stiftkontakte (810,820) oder weniger enthält.

6. Unterbaugruppe oder Vorrichtung (100) nach einem vorstehenden Anspruch, wobei sowohl in der ersten als auch der zweiten PCB-Baugruppe (110,120):
jeder Stift (118,128) eine Längsachse aufweist, entlang derer er sich erstreckt, und die Längsachsen jedes Stifts in der Reihe paralleler Stifte (118,128) in einer ersten Richtung (10) ausgerichtet sind; und
die Reihe paralleler Stifte (118,128) sich in einer zweiten Richtung (20) senkrecht zu der ersten Richtung (10) erstreckt, und wobei optional
die Reihen von Stiften (118,128), die von der ersten und der zweiten PCB-Baugruppe (110,120) bereitgestellt sind, voneinander in einer dritten Richtung (30) beabstandet sind, die senkrecht zu der ersten (10) und der zweiten Richtung (20) verläuft.

7. Unterbaugruppe oder Vorrichtung (100) nach einem vorstehenden Anspruch, wobei sich jeder Stift durch eine Bohrung (405) in dem Stiftträger (116,126) erstreckt, von dem er gehalten wird, wobei die Bohrung (405) eine oder mehrere Vertiefungen (403) umfasst und jeder Stift (118,128) einen Zwischenabschnitt (404) umfasst, der sich innerhalb der Bohrung (405) des Stiftträgers befindet, wobei der Zwischenabschnitt (404) des Stifts einen oder mehrere Fortsätze (408) umfasst, wobei jeder Fortsatz (408) mit einer Vertiefung (403) der Bohrung (405) des Trägers (116,126), durch die sich der Stift erstreckt, zusammenwirkt, um den Stift (118,128) relativ zu dem Stiftträger (116,126) in Position zu halten.

8. Unterbaugruppe oder Vorrichtung (100) nach einem vorstehenden Anspruch, wobei der Stiftträger (116,126) ein einteiliger Stiftträger (116,126) ist, und/oder
wobei der Stiftträger (116,126) ganzheitlich gegossen ist, wobei optional der Stiftträger (116,126) ganzheitlich um die Stifte (118,128) gebildet worden ist, und/oder
wobei der Stiftträger (116,126) in der Form eines Streifens ist.

9. Unterbaugruppe oder Vorrichtung (100) nach einem vorstehenden Anspruch, wobei:
der Stiftträger (116,126) einen oder mehrere Fortsätze (510,520) umfasst, jeder Fortsatz (510,520) mit einer jeweiligen von einer oder mehrerer Vertiefungen (512,522) in der PCB (112,122) der PCB-Baugruppe (110,120) zusammenwirkt, von der der Stiftträger (116,126) und die PCB (112,122) einen Teil bilden, um den Stiftträger (116,126) auf der PCB (112,122) zu montieren, wobei optional jeder Fortsatz ein Haken oder Zapfen (510,520) ist und jede Vertiefung ein Loch (512,522) durch die PCB (112,122) ist.

10. Unterbaugruppe oder Vorrichtung (100) nach einem vorstehenden Anspruch, wobei die Stiftbaugruppe (114,124) einen oder mehrere planare Bereiche (412,422) umfasst, die dazu konfiguriert sind, mit einer Pick-and-Place-Maschine kuppelbar zu sein.

11. Unterbaugruppe oder Vorrichtung (100) nach einem vorstehenden Anspruch, wobei die PCBs (112,122) der ersten und der zweiten PCB-Baugruppe (110,120) in einer gestapelten Anordnung in Bezug aufeinander angeordnet sind.

12. Verfahren zum Verwenden der Vorrichtung (100) nach einem der Ansprüche 3 bis 11, umfassend:
Verbinden der Vorrichtung mit einem OBD-Anschluss eines Fahrzeugs; und
Verwenden der Vorrichtung (100), um Daten von dem Fahrzeug mittels des OBD-Anschlusses zu erhalten, wobei das Verfahren weiter optional umfasst, dass die Vorrichtung (100) Ausgabedaten basierend auf den erhaltenen Daten über eine drahtlose Kommunikationsschnittstelle, optional an einen Server, überträgt.

13. Verfahren zum Herstellen einer OBD-Vorrichtung (100) nach einem der Ansprüche 3 bis 11, umfassend:
Erhalten der ersten PCB-Baugruppe (110) und der zweiten PCB-Baugruppe (120), wobei Erhalten jeder PCB-Baugruppe (110,120) umfasst:
Platzieren von Lötpaste auf einer PCB (112,122) für die PCB-Baugruppe (110,120);
Einrichten der Stiftbaugruppe (114,124) relativ zu der PCB (112,122) unter Verwendung einer Pick-and-Place-Maschine, sodass Lötpaste zwischen mindestens einem Ende jedes der Stifte (118,128) der Stiftbaugruppe (114,124) und der PCB (112,122) positioniert wird; und
Erhitzen der PCB (112,122) und der Stiftbaugruppe (114,124), wobei die Lötpaste zwischen dem mindestens einen Ende jedes der Stifte (118,128) und der PCB (112,122) eine Lötverbindung bildet, die das mindestens eine Ende des Stifts an die PCB (112,122) bondet; und
optional weiter umfassend: Aufbringen von Lötpaste auf die PCB (112,122) an anderen Stellen für die Verbindung einer Vielzahl anderer Komponenten mit der PCB (112,122), Einrichten der anderen Komponenten der PCB (112,122) relativ zu der PCB (112,122) unter Verwendung einer Pick-and-Place-Maschine, wobei Lötpaste zwischen jeder Komponente und der PCB (112,122) positioniert wird, und Bonden der anderen Komponenten an die PCB (112,122) gemeinsam mit den Stiften während des Heizschritts.

14. Verfahren nach Anspruch 13, weiter umfassend die zusätzlichen Schritte:
Verbinden der ersten PCB-Baugruppe (110) mit der zweiten PCB-Baugruppe (120);
Bereitstellen eines Gehäuses (800) für die OBD-Vorrichtung (100), wobei optional das Gehäuse (800) ein Verbindergehäuse (842) umfasst und das Verfahren Einsetzen der Reihen paralleler Stiftkontakte (810,820), die von sowohl der ersten als auch der zweiten PCB-Baugruppe (110,120) bereitgestellt werden, durch jeweilige Schlitze in das Verbindergehäuse (842) für die Vorrichtung umfasst;
und Positionieren der ersten und der zweiten PCB-Baugruppe (110,120) relativ zu dem Gehäuse (800), wobei die PCB-Baugruppen (110,120) so eingerichtet sind, dass die Reihen paralleler Stiftkontakte (810,820), die von der ersten beziehungsweise der zweiten PCB-Baugruppe (110,120) bereitgestellt werden, jeweilige Reihen paralleler Stiftkontakte (810,820) eines Verbinders der OBD-Vorrichtung (100) bereitstellen.

15. Verfahren nach einem der Ansprüche 13 oder 14,
weiter umfassend Bereitstellen der Stiftbaugruppe (114,124), wobei der Schritt zum Bereitstellen der Stiftbaugruppe (114,124) Bilden der Stiftbaugruppe (114,124) durch ganzheitliches Gießen des Stiftträgers (116,126) um die Stifte umfasst.

## Revendications

1. Sous-ensemble pour un dispositif de diagnostic embarqué (OBD) (100) configuré pour être connecté à un port OBD d'un véhicule en cours d'utilisation, le sous-ensemble comprenant :
un premier ensemble de circuits imprimés (110) ; et
un second ensemble de circuits imprimés (120) ;
dans lequel chacun des premier et second ensembles de circuits imprimés (110,120) comprend :
un circuit imprimé (112,122) ; et
un ensemble de broches (114,124), l'ensemble de broches (114,124) comprenant :
un support de broches (116,126) ; et
une rangée de broches parallèles (118, 128) retenues par le support de broches (116, 126), dans lequel chaque broche de la rangée de broches (118, 128) comprend une partie proximale (402) s'étendant à partir d'un côté du support de broches (116, 126), au moins une extrémité proximale de la broche étant connectée au circuit imprimé (112, 122), et une partie distale (406) s'étendant à partir d'un côté opposé du support de broches (116, 126) pour fournir un contact de broche du dispositif, dans lequel la rangée de broches parallèles (118, 128) retenues par le support de broches (116, 126) fournit une rangée de contacts de broche parallèles (810, 820) ;
dans lequel les premier et second ensembles de circuits imprimés (110, 120) sont situés l'un par rapport à l'autre pour permettre aux rangées de contacts de broche parallèles fournies par les premier et second ensembles de circuits imprimés (110, 120) respectivement de fournir des rangées respectives de contacts de broche parallèles (810, 820) d'un connecteur du dispositif en cours d'utilisation, les contacts de broche (810, 820) étant disposés de manière à pouvoir être reçus par les ouvertures d'un port OBD lorsque le dispositif OBD (100) est connecté à un port OBD d'un véhicule.

2. Sous-ensemble selon la revendication 1, dans lequel le premier ensemble de circuits imprimés (110) et le second ensemble de circuits imprimés (120) sont assemblés l'un à l'autre, facultativement dans lequel les circuits imprimés (112, 122) des premier et second ensembles de circuits imprimés (110, 120) sont assemblés à l'aide de première et seconde pièces (119, 129) qui peuvent glisser l'une par rapport à l'autre sur une distance donnée tout en conservant une connexion électrique et mécanique entre les ensembles (110, 120).

3. Dispositif de diagnostic embarqué (OBD) (100), configuré pour être connecté à un port OBD d'un véhicule en cours d'utilisation, comprenant le sous-ensemble selon la revendication 1 ou 2.

4. Sous-ensemble ou dispositif (100) selon une quelconque revendication précédente, dans lequel les broches (118, 128) sont droites.

5. Sous-ensemble ou dispositif (100) selon une quelconque revendication précédente, dans lequel les contacts de broche (810, 820) du connecteur sont disposés conformément à la norme ISO 15031 et/ou dans lequel chaque rangée de broches (118, 128) contient 8 contacts de broche (810, 820) ou moins.

6. Sous-ensemble ou dispositif (100) selon une quelconque revendication précédente, dans lequel, dans chacun des premier et second ensembles de circuits imprimés (110, 120) :
chaque broche (118, 128) présente un axe longitudinal le long duquel elle s'étend, et les axes longitudinaux de chaque broche de la rangée de broches parallèles (118, 128) sont alignés dans une première direction (10) ; et
la rangée de broches parallèles (118, 128) s'étend dans une seconde direction (20) perpendiculaire à la première direction (10), et facultativement dans lequel
les rangées de broches (118, 128) fournies par les premier et second ensembles de circuits imprimés (110, 120) sont espacées les unes des autres dans une troisième direction (30), perpendiculaire aux première (10) et deuxième (20) directions.

7. Sous-ensemble ou dispositif (100) selon une quelconque revendication précédente, dans lequel chaque broche s'étend à travers un alésage (405) du support de broches (116, 126) par lequel elle est retenue, l'alésage (405) comprenant un ou plusieurs évidements (403), et chaque broche (118, 128) comprend une partie intermédiaire (404) qui est située à l'intérieur de l'alésage (405) du support de broches, la partie intermédiaire (404) de la broche comprenant une ou plusieurs saillies (408), chaque saillie (408) coopérant avec un évidement (403) de l'alésage (405) du support (116, 126) à travers lequel la broche s'étend, pour retenir la broche (118, 128) en position par rapport au support de broches (116, 126).

8. Sous-ensemble ou dispositif (100) selon une quelconque revendication précédente, dans lequel le support de broches (116, 126) est un support de broches d'une seule pièce (116, 126), et/ou
dans lequel le support de broches (116, 126) est moulé d'une seule pièce, facultativement dans lequel le support de broches (116, 126) a été formé d'une seule pièce autour des broches (118, 128), et/ou
dans lequel le support de broches (116, 126) se présente sous la forme d'une bande.

9. Sous-ensemble ou dispositif (100) selon une quelconque revendication précédente, dans lequel :
le support de broches (116, 126) comprend une ou plusieurs saillies (510, 520), chaque saillie (510, 520) coopérant avec l'un respectif d'un ou plusieurs évidements (512, 522) dans le circuit imprimé (112, 122) de l'ensemble de circuits imprimés (110, 120) dont font partie le support de broches (116, 126) et le circuit imprimé (112, 122) font partie, de manière à monter le support de broches (116, 126) sur le circuit imprimé (112, 122), facultativement dans lequel chaque saillie est un crochet ou une cheville (510, 520), et chaque évidement est un trou (512, 522) à travers le circuit imprimé (112, 122).

10. Sous-ensemble ou dispositif (100) selon une quelconque revendication précédente, dans lequel l'ensemble de broches (114, 124) comprend une ou plusieurs régions planes (412, 422) configurées pour pouvoir être engagées avec une machine de prise et de dépose.

11. Sous-ensemble ou dispositif (100) selon une quelconque revendication précédente, dans lequel les circuits imprimés (112, 122) des premier et second ensembles de circuits imprimés (110, 120) sont positionnés dans un arrangement empilé l'un par rapport à l'autre.

12. Procédé d'utilisation du dispositif (100) selon l'une quelconque des revendications 3 à 11, comprenant :
la connexion du dispositif à un port OBD d'un véhicule ; et
l'utilisation du dispositif (100) pour obtenir des données du véhicule par l'intermédiaire du port OBD, facultativement dans lequel le procédé comprend en outre la transmission par le dispositif (100) de données de sortie basées sur les données obtenues par l'intermédiaire d'une interface de communication sans fil, facultativement à un serveur.

13. Procédé de fabrication d'un dispositif OBD (100) selon l'une quelconque des revendications 3 à 11, comprenant :
l'obtention du premier ensemble de circuits imprimés (110) et du second ensemble de circuits imprimés (120), dans lequel l'obtention de chaque ensemble de circuits imprimés (110, 120) comprend :
le placement de la pâte à braser sur un circuit imprimé (112, 122) pour l'ensemble de circuits imprimés (110, 120) ;
le positionnement de l'ensemble de broches (114, 124) par rapport au circuit imprimé (112, 122) à l'aide d'une machine de prise et de dépose de sorte que la pâte à braser soit positionnée entre au moins une extrémité de chacune des broches (118, 128) de l'ensemble de broches (114, 124) et le circuit imprimé (112, 122) ; et
le chauffage du circuit imprimé (112, 122) et de l'ensemble de broches (114, 124), dans lequel la pâte à braser entre la au moins une extrémité de chacune des broches (118, 128) et le circuit imprimé (112, 122) forme une connexion soudée liant la au moins une extrémité de la broche au circuit imprimé (112, 122) ; et
facultativement, comprenant en outre : l'application de pâte à braser sur le circuit imprimé (112, 122) à d'autres endroits pour la connexion d'une pluralité d'autres composants au circuit imprimé (112, 122), la localisation des autres composants du circuit imprimé (112, 122) par rapport au circuit imprimé (112, 122) à l'aide d'une machine de prise et de dépose, dans laquelle la pâte à braser est positionnée entre chaque composant et le circuit imprimé (112, 122), et la liaison des autres composants au circuit imprimé (112, 122) avec les broches au cours de l'étape de chauffage.

14. Procédé selon la revendication 13, comprenant en outre les étapes supplémentaires consistant à :
relier le premier ensemble de circuits imprimés (110) au second ensemble de circuits imprimés (120) ;
fournir un boîtier (800) pour le dispositif OBD (100), facultativement dans lequel le boîtier (800) comprend un boîtier de connecteur (842) et le procédé comprend l'insertion des rangées de contacts de broche parallèles (810, 820) fournis par chacun des premier et second ensembles de circuits imprimés (110, 120) à travers des fentes respectives dans le boîtier de connecteur (842) pour le dispositif ;
et positionner les premier et second ensembles de circuits imprimés (110, 120) par rapport au boîtier (800) avec les ensembles de circuits imprimés (110, 120) situés de manière à ce que les rangées de contacts de broche parallèles (810, 820) fournis par les premier et second ensembles de circuits imprimés (110, 120) fournissent respectivement des rangées respectives de contacts de broche parallèles (810, 820) d'un connecteur du dispositif OBD (100).

15. Procédé selon l'une quelconque des revendications 13 ou 14 :
comprenant en outre la fourniture de l'ensemble de broches (114, 124), dans lequel l'étape de fourniture de l'ensemble de broches (114, 124) comprend la formation de l'ensemble de broches (114, 124) par moulage intégral du support de broches (116, 126) autour des broches.
